# EUROPEAN PATENT APPLICATION

(11) **EP 4 697 374 A1**
(43) Date of publication of application: **18.02.2026**
(21) Application number: 24194634.2
(22) Date of filing: 14.08.2024
(51) Int. Cl.: H01J 37/32

(54) **SYSTEM AND METHOD FOR PLASMA GENERATION**

(71) Applicant: Rohde & Schwarz GmbH & Co. KG, 81671 München (DE)
(72) Inventor: FRUEHAUF, Adrian, 81671 München (DE); OHNIMUS, Florian, 81671 München (DE); PIETZKA, Mathias, 81671 München (DE)
(74) Representative: Prinz & Partner mbB

(57) **Abstract**

The invention relates to a system (10) for plasma generation. The system (10) comprises a radio frequency, RF, generator module (12), a matching network (14) and at least one plasma chamber (16). The matching network (14) is connected to an output interface (20) of the RF generator module (12) such that the matching network (14) is arranged between the RF generator module (12) and the plasma chamber (16). The RF generator module (12) is configured to output via the output interface (20) an RF signal. The RF generator module (12) has at least one amplifier (18) with an amplifier output impedance (Z_{A}). The RF generator module (12) has a generator output impedance (Z_{G}). The system (10) comprises a control module (28) that is configured to control the matching network (14) in dependence of an RF power to be outputted via the output interface (20), thereby adapting the amplifier output impedance (Z_{A}) of the at least one amplifier (18) and the generator output impedance (Z_{G}) of the RF generator module (12) in order to perform a load modulation of the at least one amplifier (18) and the RF generator module (12). Further, a method for plasma generation is described.

## Description

The invention relates to a system for plasma generation. Further, the invention relates to a method for plasma generation by means of a system for plasma generation.

For igniting and maintaining a plasma, usually a radio frequency, RF, generator module is connected to a chamber feed unit that transfers a power of the RF signal generated by the RF generator module into a plasma chamber containing the plasma.

As the impedance of the plasma usually differs significantly from commonly used interface impedances, e.g. 50 Ohm, and as the impedance can vary significantly over time and power level, it is common in the state of the art to provide an impedance matching network in order to optimize the efficiency of the power transfer into the plasma.

The efficiency of the RF generator module may however still be reduced in case the RF generator module is not operated with its maximum available power. In the state of the art, this problem is overcome by means of a switching amplifier that is controlled via a pulse width modulated, PWM, control signal. In addition, a supply voltage of the RF generator module may be lowered in order to increase the efficiency of the RF generator module.

In US 2023/ 0246607 A1, it is described that the RF generator module comprises several amplifiers that are controlled such that an out-phasing takes place in order to perform a load modulation and to increase the efficiency of the RF generator module. Moreover, it is mentioned in US 2023/ 0246607 A1 that the impedance matching network is adapted to the number of the several amplifiers activated. In other words, a respective output impedance of the amplifiers is fixed, wherein an output impedance of the RF generator module solely depends on the number of activated amplifiers. Put differently, the output impedance of a combiner, which is associated with the output impedance of the RF generator module, changes when different combinations of the plurality of amplifiers are selected, wherein the impedance matching network converts the changing output impedance of the RF generator module, e.g. the combiner, to match the impedance of the load. Actually, this concept is necessary for implementing the out-phasing principle of the different amplifiers for load modulation, wherein each amplifier generates an RF signal.

This concept however still has drawbacks with regard to the overall efficiency and, therefore, the object of the present invention is to provide a system and method for plasma generation, allowing improved efficiency.

The invention provides a system for plasma generation. The system comprises a radio frequency, RF, generator module, a matching network and at least one plasma chamber. The matching network is connected to an output interface of the RF generator module such that the matching network is arranged between the RF generator module and the plasma chamber. The RF generator module is configured to output via the output interface an RF signal. The RF generator module has at least one amplifier with an amplifier output impedance, wherein the RF generator module has a generator output impedance. Further, the system comprises a control module that is configured to control the matching network in dependence of an RF power to be outputted via the output interface, thereby adapting the amplifier output impedance of the at least one amplifier and the generator output impedance of the RF generator module in order to perform a load modulation of the at least one amplifier and the RF generator module.

Furthermore, the invention also provides a method for plasma generation by means of a system for plasma generation. A radio frequency, RF, generator module is connected to at least one plasma chamber via a matching network that is connected to an output interface of the RF generator module. The RF generator module has at least one amplifier with an amplifier output impedance. A control module controls the matching network in dependence of an RF power to be outputted via the output interface, thereby adapting the amplifier output impedance of the at least one amplifier in order to perform a load modulation of the at least one amplifier, and wherein the RF generator module outputs an RF signal via the output interface.

Therein and in the following, the term "module" is understood to describe suitable hardware, suitable software, or a combination of hardware and software that is configured to have a certain functionality.

The hardware may, inter alia, comprise a CPU, a GPU, an FPGA, an ASIC, or other types of electronic circuitry, and/or electronic components such as resistors, capacitors, and/or inductors.

The invention is based on the idea that the matching network is controlled in dependence of an RF power to be outputted via the output interface so as to provide a load modulation of the at least one amplifier of the RF generator module. In other words, both the amplifier output impedance of the at least one amplifier as well as the generator output impedance of the RF generator module by the controlling that is performed by the matching network in dependency of the RF power to be outputted. As indicated above, the load modulation of the at least one amplifier in dependency of the RF power is realized by controlling the matching network accordingly. Actually, the load varies with time so that the generator output impedance and the amplifier output impedance also vary with time.

The generator output impedance is passed through to the at least one amplifier, as the amplifier output impedance is adapted in dependency of the RF power to be outputted. Put differently, the amplifier output impedance is modulated based on the load, namely connected with the RF generator module.

Generally, the amplifier output impedance of the at least one amplifier and the generator output impedance of the RF generator module are adapted in a stepless manner, as the adaption takes place based on the RF power to be outputted via the output interface. In contrast thereto, US 2023/ 0246607 A1 shows an adaption of the generator output impedance of the RF generator module in a stepwise manner, namely depending on the number of amplifiers activated. Moreover, an amplifier output impedance of the amplifiers is not done in US 2023/ 0246607 A1. Moreover, the adaption of the matching network is not done in US 2023/ 0246607 A1 for performing a load modulation, particularly of the amplifiers and the RF generator modulator, as the load modulation is done by means of the out-phasing.

In fact, the amplifier output impedance as well as the generator output impedance vary over time since they depend on the RF power to be outputted via the output interface, which varies over time. In other words, the amplifier output impedance and the generator output impedance may be regarded as functions that depend on time.

Accordingly, the generator output impedance depends on time and the RF power to be outputted (which varies over time), wherein the generator output impedance is passed through to the at least one amplifier such that the amplifier output impedance also depends on time and the RF power to be outputted.

In case the RF generator module comprises only one amplifier, the generator output impedance corresponds to the amplifier output impedance and vice versa. In other words, the generator output impedance equals the amplifier output impedance.

An aspect provides that the RF generator module comprises two or more amplifiers, each having an amplifier output impedance. The control module is configured to control the matching network in dependence of the RF power to be outputted via the output interface, thereby performing load modulations of the two or more amplifiers. Particularly, the amplifier output impedances of the two or more amplifiers are equal with respect to each other. The power provided by the RF generator module can be altered by means of the two or more amplifiers since the amplifiers may be controlled by means of the control module in a desired manner, e.g. switched on or switched off, so as to generate the RF power to be outputted.

Particularly, the RF generator module comprises a combiner connected with the two or more amplifiers. In case the system, particularly the RF generator module, comprises several amplifiers, the RF generator module comprises a combiner that is located between the several amplifiers and the output interface. The combiner combines the respective RF signals generated by the individual amplifiers, thereby obtaining a combined RF signal that is forwarded to the output interface. The combiner transforms the respective output impedance in a random, but fixed manner. This means that the combiner ensures that the generator output impedance is passed through to the amplifiers.

A further aspect provides that the generator output impedance of the RF generator module is proportional to the amplifier output impedance of the at least one amplifier or even equals the amplifier output impedance of the at least one amplifier. Particularly, the generator output impedance is straight proportional to the amplifier output impedance of the at least one amplifier, as it depends on the number of amplifiers activated. In other words, the generator output impedance depends on the number of amplifiers used. In fact, the generator output impedance of the RF generator module may be a multiple of the amplifier output impedance provided that two or more amplifiers are used for generating the RF signal. In case of a single amplifier, the generator output impedance equals the amplifier output impedance of the single amplifier.

Moreover, the system may be configured to set the matching network in dependence of the RF power to be outputted via the output interface such that the at least one amplifier is operated with an optimized efficiency with respect to the RF power to be outputted. The maximum efficiency can be achieved in case the amplifier is operated with an actual power equal to its maximum available power for a given load. As indicated above, the matching network is set depending on the RF power to be outputted in order to perform the load modulation. The actual power of the amplifier may deviate from the maximum power of the amplifier for the given load by 20%, preferably by 10%. Hence, the actual power may be 20 % or 10 % lower than the maximum available power for the given load.

A further aspect provides that the control module is configured to adapt the matching network such that an equivalent load is connected with the amplifier, which ensures that the RF power to be made available is just obtained. Hence, the matching network is set such that the amplifier is operated at least close to the maximum power of the amplifier for the given load, thereby providing the load modulation, namely the adaption of the amplifier output impedance in dependence of the load and/or the RF power to be outputted.

The system may comprise a measurement module configured to measure at least one impedance-indicative parameter that is indicative of an impedance in the system. The control module is connected with the measurement module and configured to receive information about the impedance-indicative parameter measured. The control module is configured to control the matching network based on the received information about the at least one impedance-indicative parameter measured. In other words, the at least one impedance-indicative parameter is measured by the measurement module, which is indicative of the impedance in the system, wherein information about the at least one impedance-indicative parameter measured is received by the control module that is connected with the measurement module. The control module controls the matching network based on the received information about the at least one impedance-indicative parameter measured. Hence, a real-time adaption of the amplifier output impedance and/or the generator output impedance can be realized since the at least one impedance-indicative parameter measured is used for controlling the matching network.

Generally, the matching network is set by the control module such that the at least one amplifier is operated with an actual impedance/load condition higher than it would be required to generate the maximum available power (for the load).

Since the amplifier is operated with an actual load condition/impedance higher than it would be required to generate the maximum available power, the amplifier is operated with a high(er) efficiency, e.g. in a region of high efficiency. The efficiency increases with increasing output power up to the maximum output power. In fact, the matching network may be set by the control module such that the amplifier is operated in or close to saturation region.

In other words, the matching network may be controlled such that a willful mismatch is provided, which causes the amplifier to be operated with an actual load condition/impedance higher than it would be required to generate the maximum available power for the actual load.

Depending on the power to be outputted, the amplifier wants to see a different load. This different load, namely the load the amplifier wants to see, is made available to the amplifier accordingly via the matching network since the matching network is set accordingly by means of the control module. The matching network ensures that the amplifier is operated in an optimal manner, namely for obtaining the maximum efficiency as indicated above.

Accordingly, it is not necessary anymore to adapt the supply voltage of the amplifier, but this could be done additionally.

Particularly, the measurement module is configured to determine an actual impedance based on the at least one impedance-indicative parameter measured and/or wherein the at least one impedance-indicative parameter is a current, a voltage or a phase. Hence, a current, a voltage or a phase is measured, based on which the impedance is determined. The matching network is controlled by means of the control module based on the impedance measured.

A further aspect provides that the measurement module is configured to measure the at least one impedance-indicative parameter at the RF generator module, between the RF generator module and the matching network, at the matching network or between the matching network and the plasma chamber. For instance, the measurement module is configured to measure several impedance-indicative parameters, for instance at different locations within the system. Based on the information gathered, the control module is enabled to control the matching network accordingly.

Furthermore, the at least one amplifier may be a linear amplifier or a switching amplifier. The linear amplifier may be a vertical metal oxide semiconductor, VMOS, or a laterally-diffused metal-oxide semiconductor, LDMOS, amplifier. Accordingly, a robust and simplified circuit technology may be established as no further circuitry is necessary. Compared to reducing the supply voltage, the controlling is simplified significantly. Moreover, the controlling can be performed in a more agile manner compared to reducing the supply voltage, particularly in real time, so as to react on changing loads.

According to another aspect, the control module is configured to adapt the matching network such that the plasma chamber is connected to the RF generator module in a lossless manner via the matching network. Therefore, the overall efficiency can be increased.

The system may comprise a storage medium with a lookup table with entries for control parameters to be used by the control module. The control module is configured to access the storage medium. The lookup table may comprise entries about the impedance determined or the impedance-indicative parameter measured, which are related to control parameters. Hence, the control module is enabled to set the matching network in dependency of the impedance determined or the impedance-indicative parameter measured while accessing the lookup table.

Alternatively or additionally, the system comprises a processing circuit that is configured to provide control parameters to be used by the control module. On the processing circuit, an artificial intelligence, e.g. a machine learning module, an artificial neuronal network or similar, may be implemented, which is trained to output control parameters to be used by the control module based on input parameters, for instance the impedance determined or the impedance-indicative parameter measured. A control-loop or an optimizer may also be implemented on the processing circuit, which is used for controlling the matching network accordingly.

For instance, the RF generator module and the matching network are commonly housed in a housing that has a common output interface to which the at least one plasma chamber is connected. Hence, a common housing is provided that encompasses the RF generator module and the matching network. Without that common housing, particularly the common output interface provided at the common housing, a 50 Ohm generator output impedance is typically provided between amplifier and matching network, which can be avoided by means of the common output interface provided at the common housing. Specifically, the common output interface may provide a generator output impedance being different to the 50 Ohm generator output impedance, particularly lower than 50 Ohm.

The foregoing aspects and many of the attendant advantages of the claimed subject matter will become more readily appreciated as the same become better understood by reference to the following detailed description, when taken in conjunction with the accompanying drawings, wherein:
- Figure 1 schematically shows a system for plasma generation according to an embodiment of the invention,
- Figure 2 schematically shows the system for plasma generation according to Figure 1 in a different illustration, and
- Figure 3 schematically shows an overview illustrating a method for plasma generation according to an embodiment of the invention.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

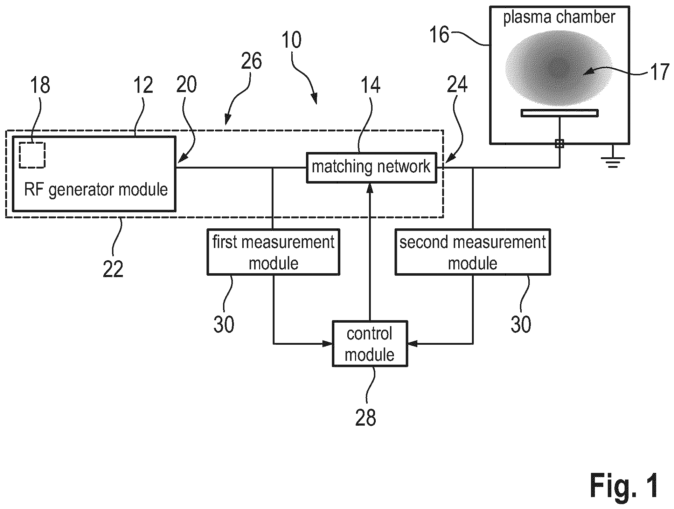

In Figure 1, a system 10 for plasma generation is shown, which comprises a radio frequency, RF, generator module 12, a matching network 14 and at least one plasma chamber 16 in which a plasma 17 is provided.

The RF generator module 12 comprises at least one amplifier 18, for instance a linear amplifier or a switching amplifier, which is used to provide a radio frequency signal. The RF generator module 12 has an output interface 20 as well as a generator output impedance.

In the shown embodiment of Figure 1, the RF generator module 12 and the matching network 14 are commonly housed in a common housing 22 that has a common output interface 24 to which the at least one plasma chamber 16 is connected. Hence, a combo box 26 is established that encompasses both the RF generator module 12 and the matching network 14. Accordingly, the combo box 26 comprises the common output interface 24. However, the common housing 22 and the combo box 26 is only optional such that the RF generator module 12 and the matching network 14 may also be provided by separate components.

Generally, the RF generator module 12 and the matching network 14 are arranged such that the matching network 14 is located between the RF generator module 12 and the at least one plasma chamber 16.

In the shown embodiment, the matching network 14 is directly connected to the output interface 20 of the RF generator module 12 and the common output interface 20 of the combo box 26.

The system 10 further comprises a control module 28 that is configured to control the matching network 14 in dependence of an RF power to be outputted via the output interface 20. The controlling performed by the control module 28 may be done bases on at least one impedance-indicative parameter.

For this purpose, the system 10 comprises a measurement module 30 that is configured to measure the at least one impedance-indicative parameter, for instance a current, a voltage and/or a phase. In fact, the at least one impedance-indicative parameter measured is indicative of an impedance in the system 10. The measurement module 30 may measure the at least one impedance-indicative parameter at the RF generator module 12, between the RF generator module 12 and the matching network 14, at the matching network 16 or between the matching network 14 and the plasma chamber 16. In fact, the impedance-indicative parameter may be obtained at different locations as indicated by the different locations for the measurement module 30 in Figure 1. Hence, the measurement module 30 measures several impedance-indicative parameters, namely at different locations within the system 10.

For controlling purposes, the control module 28 is connected with the measurement module 30 such that the at least one impedance-indicative parameter measured can be forwarded to the control module 28 directly or at least an information about the at least one impedance-indicative parameter measured. Hence, the control module 28 is enabled to control the matching network 14 based on the at least one impedance-indicative parameter measured.

Generally, the generator output impedance of the RF generator module 12 is not fixed, but variable as illustrated in Figure by "Z variable" such that the generator output impedance can be adapted, as will be described later in more detail.

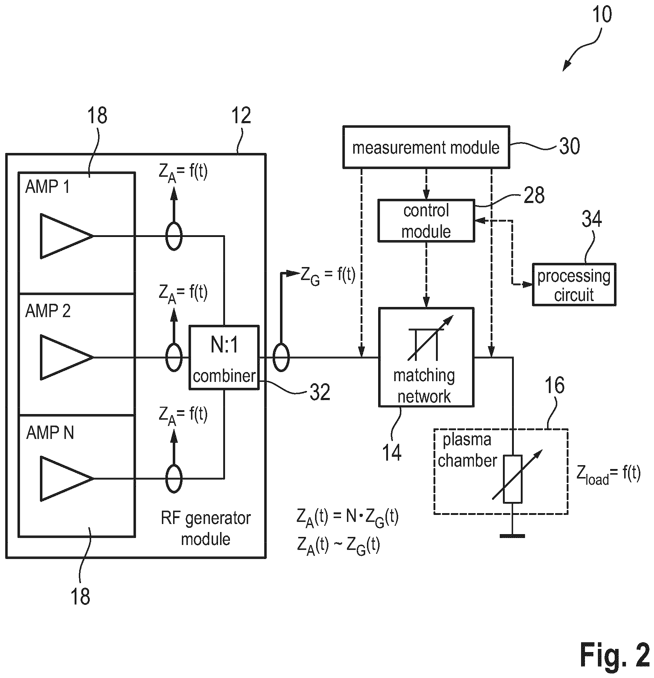

In Figure 2, the system 10 is shown in more detail, particularly the structure of the RF generator module 12. As shown, the RF generator module 12 comprises two or more amplifiers 18, e.g. N amplifiers 18, which each have an amplifier output impedance Z_{A} that is not fixed, but variable based on a setting of the matching network 14 as will be described later in more detail.

The two or more amplifiers 18 are connected via a combiner 32 to the output interface 20 of the RF generator module 12. The RF generator module 12 is connected via the output interface 20 to the matching network 14.

As illustrated in Figure 2, the plasma provided in the plasma chamber relates to a load that varies over time, thereby having a time-varying load impedance Z_{load} as indicated by being a function of time, f(t).

Hence, the impedance of the system 10 varies which can be detected by means of the measurement module 30, particularly by measuring the at least one impedance-indicative parameter. As already indicated above, the control module 28 receives the respective information from the measurement module 30 with regard to the impedance for controlling the matching network 14.

The matching network 14 is controlled by the control module 28 in dependence of an RF power to be outputted via the output interface 20, thereby adapting the amplifier output impedance of the at least one amplifier 18 and the generator output impedance of the RF generator module 12 in general. Thus, a load modulation of the at least one amplifier 18 and the RF generator module 12 can be performed.

Actually, the control module 28 controls the matching network 14 in dependence of the RF power to be outputted via the output interface 20 such that the at least one amplifier 18 is operated with an optimized efficiency with respect to the RF power to be outputted. This is ensured by adapting the matching network 14 such that an equivalent load is connected with the RF generator module 12, particularly the at least one amplifier 18, which ensures that the RF power to be made available is just obtained by the at least one amplifier 18.

Since the RF generator module 12 comprises two or more amplifiers 18 and the control module 28 controls the matching network 14 in dependence of the RF power to be outputted via the output interface 20, load modulations of the two or more amplifiers 18 are performed, as controlling of the matching network 14 causes an adaption of the generator output impedance Z_{G} of the RF generator module 12. The adaption of the generator output impedance Z_{G} of the RF generator module 12 is passed through to the amplifiers 18 so that their amplifier output impedances Z_{A} are adapted accordingly.

As shown in Figure 2, the generator output impedance Z_{G} of the RF generator module 12 is straight proportional to the amplifier output impedance Z_{A} of the amplifiers 18, namely Z_{A} = N x Z_{G}. In case of having only one amplifier 18, the generator output impedance Z_{G} even equals the amplifier output impedance Z_{A} of the single amplifier 18.

However, both the generator output impedance Z_{G} of the RF generator module 12 and the respective amplifier output impedance Z_{A} of the at least one amplifier 18 can be adapted by setting the matching network 14 accordingly. Therefore, the generator output impedance Z_{G} as well as the amplifier output impedance Z_{A} are variable with time - similar to the impedance of the load Z_{load}, namely the plasma in the plasma chamber 16. This is indicated in Figure 2 since the generator output impedance Z_{G} as well as the amplifier output impedances Z_{A} are denoted as functions of time, f(t).

Generally, the control module 28 controls or sets the matching network 14 such that the at least one amplifier 18 is operated with an actual impedance/load condition higher than it would be required to generate the maximum available power for the respective load, namely the plasma in the plasma chamber 16. Consequently, the at least one amplifier 18 is operated with a higher efficiency compared to its operation condition according to the state of the art for reaching the maximum available power for the respective load. The matching network 14 is controlled to provide a willful mismatch that causes the amplifier 18 to be operated with an actual load condition/impedance higher than it would be required to generate the maximum available power for the actual load. By doing so, it can be ensured that the efficiency of the at least one amplifier 18 is improved compared to the state of the art, thereby improving the overall efficiency of the system 10.

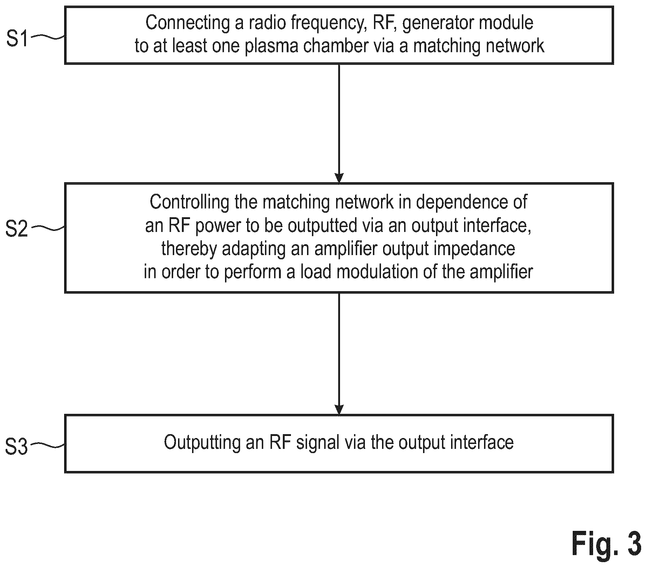

The system 10 is enabled to perform the method for plasma generation as illustrated in Figure 3.

In fact, the radio frequency, RF, generator module 12 is connected to the at least one plasma chamber 16 via the matching network 14 that is connected to an output interface 20 of the RF generator module 12. The respective connections may be established provided that the components are not connected with each other inherently, e.g. by means of the combo box 26.

The control module 28 controls the matching network 14 in dependence of the RF power to be outputted via the output interface 20, thereby adapting the amplifier output impedance of the at least one amplifier 18 in order to perform a load modulation of the at least one amplifier 18.

The RF generator module 12 outputs the RF signal via the output interface 20 that is forwarded to the plasma chamber 16 for igniting or maintaining the plasma in the plasma chamber 16.

The control module 28 may control the matching network 14 based on information gathered by the measurement module 30, namely the at least one impedance-indicative parameter that is indicative of an impedance in the system 10.

For instance, the control module 28 may determine an impedance of the matching network 14 based on the at least one impedance-indicative parameter measured by the measurement module 30. The control module 28 may compare the impedance determined with a target impedance that is to be set.

For obtaining the respective control parameters, the control module 28 may access a look-up table stored on an integrated storage medium, which comprises entries for the at least one impedance-indicative parameter and at least one associated control parameter. Thus, the control module 28 is enabled to control the matching network 14 appropriately, thereby ensuring that the matching network 14 is set in the intended manner.

Alternatively, the control module 28 may interact with a processing circuit 34 that is configured to provide control parameters to be used by the control module 28. On the processing circuit 34, a regulator, an optimizer, a control-loop or an artificial intelligence may be implemented, which is used to output the control parameters used for controlling the matching network 14.

Certain embodiments disclosed herein, particularly the respective module(s) and/or unit(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

## Claims

1. A system (10) for plasma generation, wherein the system (10) comprises a radio frequency, RF, generator module (12), a matching network (14) and at least one plasma chamber (16), wherein the matching network (14) is connected to an output interface (20) of the RF generator module (12) such that the matching network (14) is arranged between the RF generator module (12) and the plasma chamber (16), wherein the RF generator module (12) is configured to output via the output interface (20) an RF signal, wherein the RF generator module (12) has at least one amplifier (18) with an amplifier output impedance (Z_{A}), wherein the RF generator module (12) has a generator output impedance (Z_{G}), wherein the system (10) comprises a control module (28) that is configured to control the matching network (14) in dependence of an RF power to be outputted via the output interface (20), thereby adapting the amplifier output impedance (Z_{A}) of the at least one amplifier (18) and the generator output impedance (Z_{G}) of the RF generator module (12) in order to perform a load modulation of the at least one amplifier (18) and the RF generator module (12).

2. The system (10) according to claim 1, wherein the RF generator module (12) comprises two or more amplifiers (18), each having an amplifier output impedance (Z_{A}), and wherein the control module (28) is configured to control the matching network (14) in dependence of the RF power to be outputted via the output interface (20), thereby performing load modulations of the two or more amplifiers (18), in particular wherein the amplifier output impedances (Z_{A}) of the two or more amplifiers (18) are equal with respect to each other.

3. The system (10) according to claim 2, wherein the RF generator module (12) comprises a combiner (32) connected with the two or more amplifiers (18).

4. The system (10) according to any one of the preceding claims, wherein the generator output impedance (Z_{G}) of the RF generator module (12) is proportional, particularly straight proportional, to the amplifier output impedance (Z_{A}) of the at least one amplifier (18) or even equals the amplifier output impedance (Z_{A}) of the at least one amplifier (18).

5. The system (10) according to any one of the preceding claims, wherein the system (10) is configured to set the matching network (14) in dependence of the RF power to be outputted via the output interface (20) such that the at least one amplifier (18) is operated with an optimized efficiency with respect to the RF power to be outputted.

6. The system (10) according to any one of the preceding claims, wherein the control module (28) is configured to adapt the matching network (14) such that an equivalent load is connected with the amplifier (18), which ensures that the RF power to be made available is just obtained.

7. The system (10) according to any one of the preceding claims, wherein the system (10) comprises a measurement module (30) configured to measure at least one impedance-indicative parameter that is indicative of an impedance in the system (10), wherein the control module (28) is connected with the measurement module (30) and configured to receive information about the impedance-indicative parameter measured, and wherein the control module (28) is configured to control the matching network (14) based on the received information about the at least one impedance-indicative parameter measured.

8. The system (10) according to claim 7, wherein the measurement module (30) is configured to determine an actual impedance based on the at least one impedance-indicative parameter measured and/or wherein the at least one impedance-indicative parameter is a current, a voltage or a phase.

9. The system (10) according to claim 7 or 8, wherein the measurement module (30) is configured to measure the at least one impedance-indicative parameter at the RF generator module (12), between the RF generator module (12) and the matching network (14), at the matching network (14) or between the matching network (14) and the plasma chamber (16), in particular wherein the measurement module (30) is configured to measure several impedance-indicative parameters, for instance at different locations within the system (10).

10. The system (10) according to any one of the preceding claims, wherein the at least one amplifier (18) is a linear amplifier or a switching amplifier.

11. The system (10) according to any one of the preceding claims, wherein the control module (28) is configured to adapt the matching network (14) such that the plasma chamber (16) is connected to the RF generator module (12) in a lossless manner via the matching network (14).

12. The system (10) according to any one of the preceding claims, wherein the system (10) comprises a storage medium with a lookup table with entries for control parameters to be used by the control module (28), and wherein the control module (28) is configured to access the storage medium, and/or wherein the system (10) comprises a processing circuit (34) that is configured to provide control parameters to be used by the control module (28).

13. The system (10) according to any one of the preceding claims, wherein the RF generator module (12) and the matching network (14) are commonly housed in a housing (22) that has a common output interface (24) to which the at least one plasma chamber (16) is connected.

14. A method for plasma generation by means of a system (10) for plasma generation, wherein a radio frequency, RF, generator module (12) is connected to at least one plasma chamber (16) via a matching network (14) that is connected to an output interface (20) of the RF generator module (12), wherein the RF generator module (12) has at least one amplifier (18) with an amplifier output impedance (Z_{A}), wherein a control module (28) controls the matching network (14) in dependence of an RF power to be outputted via the output interface (20), thereby adapting the amplifier output impedance (Z_{A}) of the at least one amplifier (18) in order to perform a load modulation of the at least one amplifier (18), and wherein the RF generator module (12) outputs an RF signal via the output interface (20).

15. The method according to claim 14, wherein at least one impedance-indicative parameter is measured by a measurement module (30), which is indicative of an impedance in the system (10), wherein information about the at least one impedance-indicative parameter measured is received by the control module (28) that is connected with the measurement module (30), and wherein the control module (28) controls the matching network (14) based on the received information about the at least one impedance-indicative parameter measured.
